# EUROPEAN PATENT SPECIFICATION

(11) **EP 3 767 309 B1**
(45) Date of publication and mention of the grant of the patent: **08.02.2023**
(21) Application number: 19198323.8
(22) Date of filing: 19.09.2019
(51) Int. Cl.: G01R 13/02, G01R 23/20

(54) **MEASUREMENT SYSTEM AND METHOD FOR AUTOMATED MEASUREMENT OF SEVERAL CONTRIBUTIONS TO SIGNAL DEGRADATION**
MESSSYSTEM UND VERFAHREN ZUR AUTOMATISIERTEN MESSUNG MEHRERER KONTRIBUTIONEN ZUR SIGNALVERSCHLECHTERUNG
SYSTÈME DE MESURE ET PROCÉDÉ DE MESURE AUTOMATISÉE DE PLUSIEURS CONTRIBUTIONS DE DÉGRADATION DE SIGNAL

(30) Priority: 19.07.2019 US 201916517158
(43) Date of publication of application: 20.01.2021
(73) Proprietor: Rohde & Schwarz GmbH & Co. KG, 81671 München (DE)
(72) Inventor: Rüngeler, Dr., Matthias, 85570 Markt Schwaben (DE); Bunsen, Bastian, 82166 Gräfelfing (DE); Ramian, Dr., Florian, 85757 Karlsfeld (DE)
(74) Representative: Rupp, Christian

(56) References cited:
- US-A1- 2019 064 236
- US-B1- 6 697 436

## Description

The invention relates to a measurement system and a corresponding measurement method for automated measurement of several contributions to signal degradation.

Generally, in times of an increasing number of applications providing communication capabilities, there is a growing need of a measurement system and a corresponding measurement method for performing an automated measurement of several contributions to signal degradation with respect to a device under test comprising such an application in order to verify correct functioning of said applications in a highly accurate and efficient manner.

A method for measuring non-linear distortion using a multi-toned test signal is known from US 2019/0064236 A1. Further prior art can be found in US6697436.

In this context of testing, with the aid of common measuring devices or measurement systems, respectively, only one error vector magnitude (EVM) value can be measured, which describes the respective signal degradation. In addition to this, it is noted that this degradation has multiple reasons such as noise, non-linearities, frequency response/memory effects, frequency offset, I/Q imbalance, I/Q offset, phase drift, amplitude droop, or any combination thereof. Disadvantageously, as a consequence of the single error vector magnitude value, just the sum of all effects can be obtained. Therefore, as a further disadvantage, the respective device under test cannot efficiently be improved on the basis of said common measurement result.

Accordingly, there is the object to provide a measurement system and a corresponding measurement method for automated measurement of several contributions to signal degradation, whereby both a high accuracy and a high efficiency are ensured.

The object is solved by the features of the first independent claim regarding the measurement system and by the features of the second independent claim regarding the measurement method. The dependent claims comprise further developments.

Additionally, as a further advantage, the corresponding effects or contributions, respectively, can automatically be separated and optionally be displayed. In other words, the independent causes for the signal degradation can automatically be identified and quantified. Thus, a user can see at one glance which effects cause a measured error vector magnitude and not just the sum of all effects. This makes it easier for the user to decide which measures promise the biggest benefit to improve the device under test.

According to a first aspect of the invention, a measurement system for automated measurement of several contributions to signal degradation is provided. Said measurement system comprises a device under test, a signal analyzer, and a controller. In this context, the controller comprises at least one command sequence for the device under test and/or the signal analyzer. In addition to this, each of the at least one command sequence comprises respective commands to compensate for a specific cause of signal degradation. Advantageously, not only a high accuracy but also a high efficiency can be ensured. Further advantageously, the independent causes for the signal degradation can automatically be identified and quantified with the aid of the measurement system.

According to a first preferred implementation form of the first aspect of the invention, the measurement system further comprises a signal generator, wherein the controller comprises at least one command sequence for the device under test and/or the signal analyzer and/or the signal generator. Advantageously, for instance, both measurement accuracy and efficiency can further be increased.

According to the invention, the measurement system, preferably the controller of the measurement system, is configured to eliminate a certain cause of signal degradation from the device under test by running several command sequences for different combinations of compensations to obtain a compensated measurement. Advantageously, for example, not only measurement efficiency but also measurement accuracy can further be increased.

According to a further preferred implementation form of the first aspect of the invention, the measurement system, preferably the controller of the measurement system, is configured to provide a report showing the contributions of the corresponding different causes of signal degradation. Advantageously, for instance, measurement results can efficiently be displayed.

According to a further preferred implementation form of the first aspect of the invention, the signal analyzer comprises the controller. Advantageously, for example, complexity can be reduced, which leads to an increased efficiency.

According to a further preferred implementation form of the first aspect of the invention, the measurement system further comprises a personal computer, wherein the personal computer comprises the controller. Advantageously, for instance, simplicity can be increased, thereby increasing efficiency.

According to a further preferred implementation form of the first aspect of the invention, at least two of the several contributions depend upon one another. Advantageously, for example, measurement accuracy can further be increased.

According to a further preferred implementation form of the first aspect of the invention, the measurement system, preferably the controller of the measurement system, is configured to perform each permutation of at least a part of the several contributions. Advantageously, for instance, the occurrence of measurement errors can further be reduced.

According to a further preferred implementation form of the first aspect of the invention, preferably with respect to the signal analyzer, the several contributions comprise at least one of an enabled equalizer, a disabled equalizer, an enabled pre-distortion, a disabled pre-distortion, an enabled digital pre-distortion, a disabled digital pre-distortion, or any combination thereof. Advantageously, for example, both measurement efficiency and accuracy can further be increased.

According to a further preferred implementation form of the first aspect of the invention, the measurement system, preferably the controller of the measurement system, is configured to acquire a different frequency response contribution with compensated non-linearities especially by performing each permutation of at least a part of the several contributions. Advantageously, for instance, not only measurement accuracy but also measurement efficiency can further be increased.

According to a further preferred implementation form of the first aspect of the invention, the different frequency response contribution with compensated non-linearities gets different impact of unwanted linear effects. Advantageously, for example, inaccuracy can further be reduced.

According to a further preferred implementation form of the first aspect of the invention, the measurement system, preferably the controller of the measurement system, is configured to analyze a noise contribution by command sequences creating several measurements and I/Q averaging on the signal analyzer. Advantageously, for instance, measurement exactness can further be increased.

According to a further preferred implementation form of the first aspect of the invention, the measurement system, preferably the controller of the measurement system, is configured to compensate unwanted linear effects with command sequences comparing an ideal signal with the respective measured signal. Advantageously, said ideal signal may be simulated by the measurement system, preferably by the controller of the measurement system. Further advantageously, additional components are not necessary, which leads to reduced costs and an increased efficiency.

According to a further preferred implementation form of the first aspect of the invention, the measurement system, preferably the controller of the measurement system, is configured to compensate unwanted linear effects by creating respective equalized values. Advantageously, for instance, both measurement exactness and measurement efficiency can further be increased.

According to a further preferred implementation form of the first aspect of the invention, the measurement system, preferably the controller of the measurement system, is configured to compensate unwanted linear effects with command sequences comprising pre-distortion, especially digital pre-distortion. Advantageously, for example, not only accuracy but also efficiency can be increased.

According to a further preferred implementation form of the first aspect of the invention, the measurement system, preferably the controller of the measurement system, is configured to compensate unwanted linear effects with command sequences using modeling techniques, especially polynomial modeling techniques, based on the corresponding measured data. Advantageously, for instance, measurement exactness can further be increasing, thereby also increasing measurement efficiency.

According to a further preferred implementation form of the first aspect of the invention, the measurement system, preferably the controller of the measurement system, is configured to illustrate respective proportions with the aid of a pie chart. Advantageously, said illustration may be performed with the aid of a display in a highly efficient manner.

According to a further preferred implementation form of the first aspect of the invention, the measurement system, preferably the controller of the measurement system, is configured to show respective proportions with the aid of a permutations table in order to illustrate the corresponding dependencies in the contributions. Advantageously, for instance, a user can see at one glance which effects cause a measured error vector magnitude and not just the sum of all effects.

According to a further preferred implementation form of the first aspect of the invention, the measurement system, preferably the controller of the measurement system, is configured to highlight an intensity of a respective contribution with a corresponding color. Advantageously, for example, efficiency of the respective illustration can further be increased.

According to a second aspect of the invention, a measurement method for automated measurement of several contributions to signal degradation is provided. Said measurement method comprises the step of generating at least one command sequence for a device under test and/or a signal analyzer with the aid of a controller. In this context, each of the at least one command sequence comprises respective commands to compensate for a specific cause of signal degradation. Advantageously, not only a high accuracy but also a high efficiency can be ensured. Further advantageously, the independent causes for the signal degradation can automatically be identified and quantified with the aid of the measurement system.

Exemplary embodiments of the invention are now further explained with respect to the drawings by way of example only, and not for limitation. In the drawings:
- Fig. 1: shows a first exemplary embodiment of the first aspect of the invention;
- Fig. 2: shows a second exemplary embodiment of the first aspect of the invention;
- Fig. 3: shows a third exemplary embodiment of the first aspect of the invention;
- Fig. 4: shows a fourth exemplary embodiment of the first aspect of the invention;
- Fig. 5: shows a fifth exemplary embodiment of the first aspect of the invention;
- Fig. 6: shows a sixth exemplary embodiment of the first aspect of the invention; and
- Fig. 7: shows a flow chart of an exemplary embodiment of the second aspect of the invention.

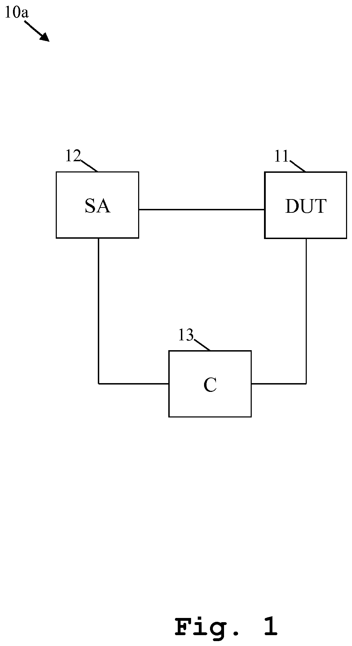

Firstly, Fig. 1 illustrates a first exemplary embodiment of the inventive measurement system 10a for automated measurement of several contributions to signal degradation.

Said measurement system 10a comprises a device under test 11, a signal analyzer 12, and a controller 13. In this context, the controller 13 comprises at least one command sequence for the device under test 11 and/or the signal analyzer 12. In addition to this, each of the at least one command sequence comprises respective commands to compensate for a specific cause of signal degradation.

As it can further be seen from Fig. 1, the signal analyzer 12 is connected to the device under test 11, whereas the controller 13 is connected to at least one of the device under test 11, the signal analyzer 12, or the combination thereof.

It is generally noted that the at least one command sequence may also comprise or be at last one test sequence. The at least one command sequence or test sequence, respectively, may be run individually and may be used to determine independent measurements.

In this context, for instance, I/Q averaging may be used to determine the respective signal-to-noise ratio, exemplarily the signal-to-noise ratio of a satellite down-link), especially without disconnecting the corresponding signal or carrier or signal carrier.

Advantageously, pure signal power and noise power can be measured separately and preferably in the same channel especially without disconnecting the corresponding signal or carrier or signal carrier. Further advantageously, especially rather than calculating the respective noise figure from a decrease in power during I/Q averaging, the derived noise power and signal power may be used to calculate the signal-to-noise ratio.

Accordingly, as it will be mentioned again in the following, on the one hand, the measurement system, preferably the controller 13 of the measurement system, may analyze a noise contribution by command sequences creating several measurements and I/Q averaging on the signal analyzer 12.

On the other hand, the signal analyzer 12 may measure pure signal power and pure noise power separately and preferably in the same channel especially without disconnecting the corresponding signal or carrier or signal carrier. In addition to this, the measurement system, preferably the controller 13 of the measurement system, may use the respective measured or derived signal power and the respective measured or derived noise power to calculate the corresponding signal-to-noise ratio. With respect to the derived signal power and the derived noise power, it is noted that the derived signal power and the derived noise power may especially be based on I/Q averaging.

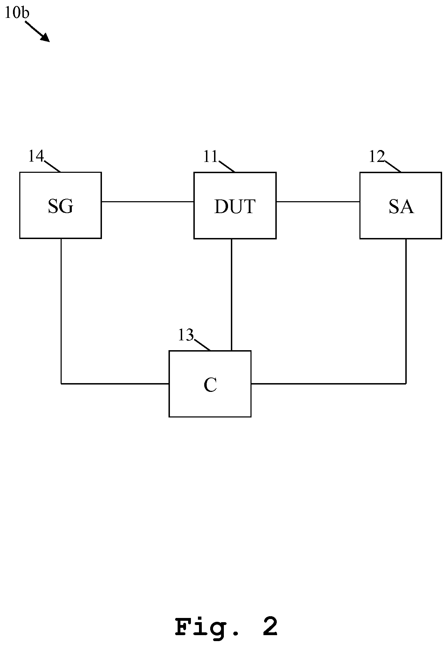

Moreover, according to a second exemplary embodiment of the measurement system 10b shown in Fig. 2, the measurement system 10b further comprises a signal generator 14.

In this context, the controller 13 comprises at least one command sequence for the device under test 11 and/or the signal analyzer 12 and/or the signal generator 14. In addition to this, each of the at least one command sequence comprises respective commands to compensate for a specific cause of signal degradation.

As it can further be seen from Fig. 2, the signal analyzer 12 is connected to the device under test 11, whereas the device under test 11 is connected to the signal generator 14. In addition to this, the controller 13 is connected to at least one of the device under test 11, the signal analyzer 12, the signal generator 14, or any combination thereof.

With respect to the each of the exemplary embodiments according to Fig. 1 to Fig. 6, it might be particularly advantageous if the measurement system 10a, 10b, 10c, 10d, 10e, 10f, preferably the controller 13 of the measurement system 10a, 10b, 10c, 10d, 10e, 10f, eliminates a certain cause of signal degradation from the device under test 11 by running several command sequences for different combinations of compensations to obtain a compensated measurement.

Further advantageously, the measurement system 10a, 10b, 10c, 10d, 10e, 10f, preferably the controller 13 of the measurement system 10a, 10b, 10c, 10d, 10e, 10f, may provide a report showing the contributions of the corresponding different causes of signal degradation.

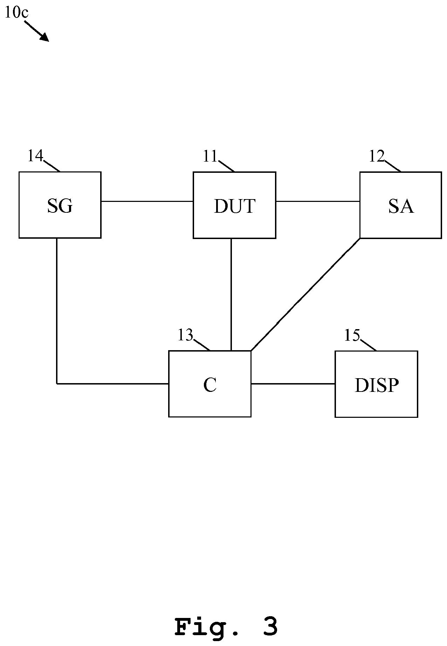

In this context, it might be particularly advantageous if the measurement system further comprises a display 15 according to the third exemplary embodiment 10c of Fig. 3. It is noted that the controller 13 may therefore be connected to the display 15. Consequently, said report can directly be shown to a user.

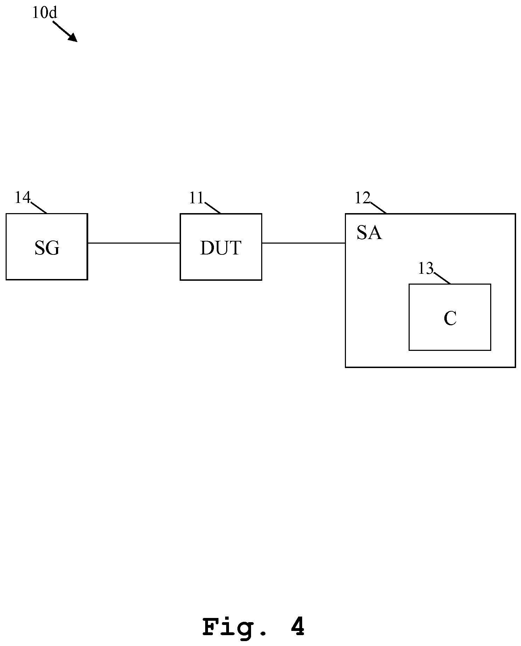

In accordance with the fourth exemplary embodiment 10d of Fig. 4, it might be particularly advantageous if the signal analyzer 12 comprises the controller 13.

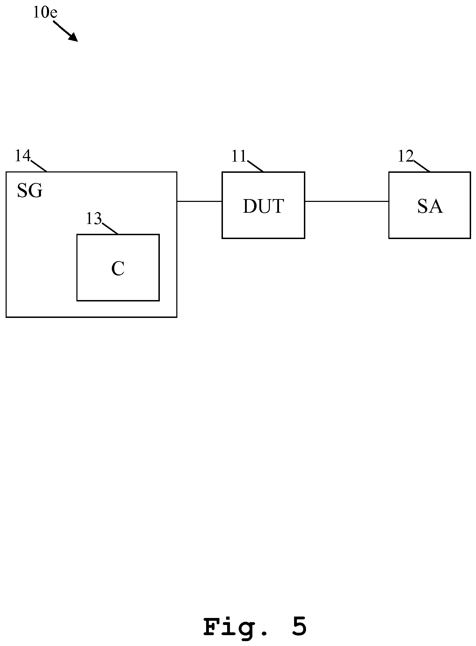

As an alternative, in accordance with fifth exemplary embodiment 10e according to Fig. 5, it might be particularly advantageous if the signal generator 14 comprises the controller 13.

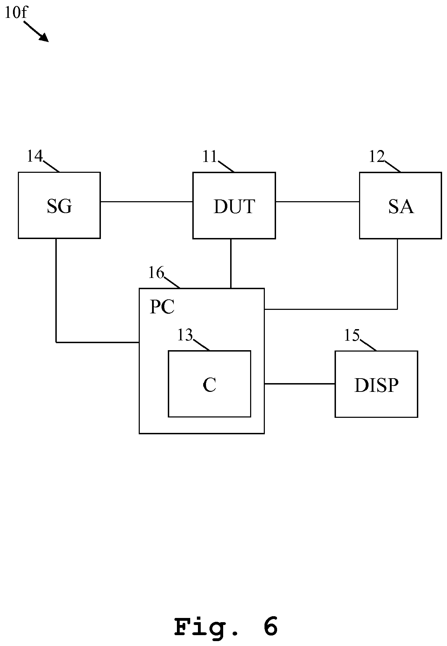

Moreover, in accordance with the sixth exemplary embodiment of inventive measurement system 10f according to Fig. 6, the measurement system 10f advantageously comprises a personal computer 16. In this context, the personal computer 16 comprises the controller 13.

As it can further be seen from said Fig. 6, the personal computer 16 may advantageously be connected to at least one of the device under test 11, the signal analyzer 12, the signal generator 14, the display 15, or any combination thereof.

As an alternative, it is noted that the controller 13 of the personal computer 16 may advantageously be connected to at least one of the device under test 11, the signal analyzer 12, the signal generator 14, the display 15, or any combination thereof.

With respect to each of the exemplary embodiments 10a, 10b, 10c, 10d, 10e, 10f, it might be particularly advantageous if at least two of the several contributions depend upon one another. Alternatively, it is noted that all of the several contributions may depend upon one another.

In addition to this or as an alternative, the measurement system 10a, 10b, 10c, 10d, 10e, 10f, preferably the controller 13 of the measurement system 10a, 10b, 10c, 10d, 10e, 10f, may advantageously perform each permutation of at least a part of the several contributions.

Further additionally or further alternatively, preferably with respect to the signal analyzer 12, the several contributions may comprise at least one of an enabled equalizer, a disabled equalizer, an enabled pre-distortion, a disabled pre-distortion, an enabled digital pre-distortion, a disabled digital pre-distortion, or any combination thereof.

In further addition to this or as a further alternative, the measurement system 10a, 10b, 10c, 10d, 10e, 10f, preferably the controller 13 of the measurement system 10a, 10b, 10c, 10d, 10e, 10f, may acquire a different frequency response contribution with compensated non-linearities especially by performing each permutation of at least a part of the several contributions.

In this context, the different frequency response contribution with compensated non-linearities may advantageously get different impact of unwanted linear effects.

Moreover, also with respect to each of the exemplary embodiments 10a, 10b, 10c, 10d, 10e, 10f, the measurement system 10a, 10b, 10c, 10d, 10e, 10f, preferably the controller 13 of the measurement system 10a, 10b, 10c, 10d, 10e, 10f, may analyze a noise contribution by command sequences creating several measurements and I/Q averaging on the signal analyzer.

In addition to this or as an alternative, the measurement system 10a, 10b, 10c, 10d, 10e, 10f, preferably the controller 13 of the measurement system 10a, 10b, 10c, 10d, 10e, 10f, may advantageously compensate unwanted linear effects with command sequences comparing an ideal signal with the respective measured signal.

Further additionally or further alternatively, the measurement system 10a, 10b, 10c, 10d, 10e, 10f, preferably the controller 13 of the measurement system 10a, 10b, 10c, 10d, 10e, 10f, may compensate unwanted linear effects by creating respective equalized values.

In further addition to this or as a further alternative, it might be particularly advantageous if the measurement system 10a, 10b, 10c, 10d, 10e, 10f, preferably the controller 13 of the measurement system 10a, 10b, 10c, 10d, 10e, 10f, compensates unwanted linear effects with command sequences comprising pre-distortion, especially digital pre-distortion.

Further additionally or further alternatively, the measurement system 10a, 10b, 10c, 10d, 10e, 10f, preferably the controller 13 of the measurement system 10a, 10b, 10c, 10d, 10e, 10f, may advantageously compensate unwanted linear effects with command sequences using modeling techniques, especially polynomial modeling techniques, based on the corresponding measured data.

In further addition to this or as a further alternative, it is noted that the measurement system 10a, 10b, 10c, 10d, 10e, 10f, preferably the controller 13 of the measurement system 10a, 10b, 10c, 10d, 10e, 10f, may illustrate respective proportions with the aid of a pie chart. In this context, it is noted that for the purpose of illustration, the display 15 may advantageously be used.

Again, with respect to each of the exemplary embodiments 10a, 10b, 10c, 10d, 10e, 10f, the measurement system 10a, 10b, 10c, 10d, 10e, 10f, preferably the controller 13 of the measurement system 10a, 10b, 10c, 10d, 10e, 10f, may advantageously show respective proportions with the aid of a permutations table in order to illustrate the corresponding dependencies in the contributions. In this context, as already mentioned above, it is noted again that for the purpose of illustration, the display 15 may advantageously be used.

Additionally or alternatively, the measurement system 10a, 10b, 10c, 10d 10e, 10f, preferably the controller 13 of the measurement system 10a, 10b, 10c, 10d, 10e, 10f, may advantageously highlight an intensity of a respective contribution with a corresponding color. In this context, as an example, red may be used for a high intensity. Further exemplarily, blue may be used for a low intensity.

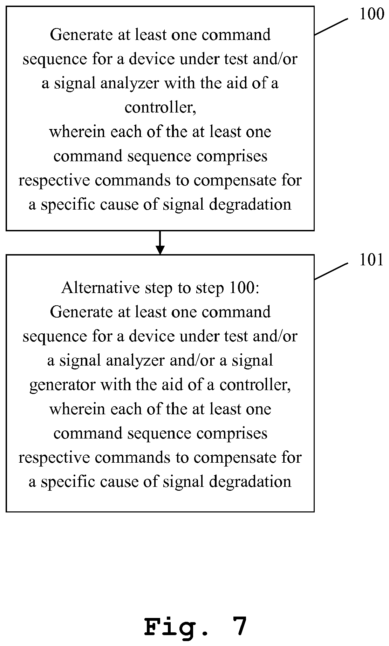

Finally, Fig. 7 shows a flow chart of an exemplary embodiment of the inventive measurement method for automated measurement of several contributions to signal degradation. In a first step 100, at least one command sequence is generated for a device under test and/or a signal analyzer with the aid of a controller, wherein each of the at least one command sequence comprises respective commands to compensate for a specific cause of signal degradation. Furthermore, in an alternative step 101 to step 100, at least one command sequence is generated for a device under test and/or a signal analyzer and/or a signal generator with the aid of a controller, wherein each of the at least one command sequence comprises respective commands to compensate for a specific cause of signal degradation.

It is generally noted that the at least one command sequence may also comprise or be at last one test sequence. The at least one command sequence or test sequence, respectively, may be run individually and may be used to determine independent measurements.

In this context, for instance, I/Q averaging may be used to determine the respective signal-to-noise ratio, exemplarily the signal-to-noise ratio of a satellite down-link), especially without disconnecting the corresponding signal or carrier or signal carrier.

Advantageously, pure signal power and noise power can be measured separately and preferably in the same channel especially without disconnecting the corresponding signal or carrier or signal carrier. Further advantageously, especially rather than calculating the respective noise figure from a decrease in power during I/Q averaging, the derived noise power and signal power may be used to calculate the signal-to-noise ratio.

Accordingly, as it will be mentioned again in the following, on the one hand, the measurement method may further comprise the step of analyzing a noise contribution on the basis of I/Q averaging, especially on the basis of a decrease in power during I/Q averaging.

On the other hand, the signal analyzer may measure pure signal power and pure noise power separately and preferably in the same channel especially without disconnecting the corresponding signal or carrier or signal carrier. In addition to this, preferably the controller may use the respective measured or derived signal power and the respective measured or derived noise power to calculate the corresponding signal-to-noise ratio. With respect to the derived signal power and the derived noise power, it is noted that the derived signal power and the derived noise power may especially be based on I/Q averaging.

In other words, the method may further comprise the step of measuring pure signal power and pure noise power separately and preferably in the same channel especially without disconnecting the corresponding signal or carrier or signal carrier. In addition to this, the method may further comprise the step of using the respective measured or derived signal power and the respective measured or derived noise power to calculate the corresponding signal-to-noise ratio. With respect to the derived signal power and the derived noise power, as already mentioned above, it is noted that the derived signal power and the derived noise power may especially be based on I/Q averaging.

It is noted that it might be particularly advantageous if the measurement method further comprises the step of eliminating a certain cause of signal degradation from the device under test by running several command sequences for different combinations of compensations to obtain a compensated measurement.

In addition to this or as an alternative, the measurement method may advantageously comprise the step of providing a report showing the contributions of the corresponding different causes of signal degradation.

It is further noted that the above-mentioned signal analyzer may advantageously comprise the controller. Moreover, the measurement method may further comprise the step of using a personal computer, wherein the personal computer especially comprises the controller. With respect to the contributions, it is noted that at least two of the several contributions may especially depend upon one another.

Additionally or alternatively, preferably with respect to the signal analyzer, the several contributions comprise at least one of an enabled equalizer, a disabled equalizer, an enabled pre-distortion, a disabled pre-distortion, an enabled digital pre-distortion, a disabled digital pre-distortion, or any combination thereof.

Furthermore, it might be particularly advantageous if the measurement method further comprises the step of performing each permutation of at least a part of the several contributions.

In addition to this or as an alternative, the measurement method may advantageously comprise the step of acquiring a different frequency response contribution with compensated non-linearities especially by performing each permutation of at least a part of the several contributions. In this context, the different frequency response contribution with compensated non-linearities may get different impact of unwanted linear effects.

Moreover, as already mentioned above, it might be particularly advantageous if the measurement method further comprises the step of analyzing a noise contribution by command sequences creating several measurements and I/Q averaging on the signal analyzer.

Additionally or alternatively, the measurement method may further comprise the step of compensating unwanted linear effects with command sequences comparing an ideal signal with the respective measured signal. Further additionally or further alternatively, the measurement method may preferably comprise the step of compensating unwanted linear effects by creating respective equalized values.

In addition to this or as an alternative, the measurement method may further comprise the step of compensating unwanted linear effects with command sequences comprising pre-distortion, especially digital pre-distortion.

In further addition to this or as a further alternative, the measurement method may advantageously comprise the step of compensating unwanted linear effects with command sequences using modeling techniques, especially polynomial modeling techniques, based on the corresponding measured data.

It is further noted that it might be particularly advantageous if the measurement method comprises the step of illustrating respective proportions with the aid of a pie chart.

Additionally or alternatively, the measurement method may preferably comprise the step of showing respective proportions with the aid of a permutations table in order to illustrate the corresponding dependencies in the contributions.

In further addition to this or as a further alternative, the measurement method may advantageously comprise the step of highlighting an intensity of a respective contribution with a corresponding color.

## Claims

1. A measurement system for automated measurement of several contributions to signal degradation, the measurement system comprising:
a device under test (11),
a signal analyzer (12), and
a controller (13),
wherein the controller (13) comprises at least one command sequence for the device under test (11) and/or the signal analyzer (12), and
wherein each of the at least one command sequence comprises respective commands that, when executed by the device under test (11) and/or the signal analyzer (12) with the aid of the controller (13), compensate for a specific cause of signal degradation, and
wherein the controller (13) of the measurement system is configured to eliminate or significantly reduce a certain cause of signal degradation from the device under test (11) by running at least one command sequence for different combinations of compensations to obtain a compensated measurement.

2. The measurement system according to claim 1,
wherein the measurement system further comprises a signal generator (14),
wherein the controller (13) comprises at least one command sequence for the device under test (11) and/or the signal analyzer (12) and/or the signal generator (14).

3. The measurement system according to claim 1 or 2,
wherein the measurement system, preferably the controller (13) of the measurement system, is configured to provide a report showing the contributions of the corresponding different causes of signal degradation and/or
wherein the signal analyzer (12) comprises the controller (13) and/or
wherein the measurement system further comprises a personal computer (16) and the personal computer (16) comprises the controller (13) and/or
wherein at least two of the several contributions depend upon one another and/or
wherein the measurement system, preferably the controller (13) of the measurement system, is configured to perform each permutation of at least a part of the several contributions and/or
wherein, preferably with respect to the signal analyzer (12), the several contributions comprise at least one of an enabled equalizer, a disabled equalizer, an enabled pre-distortion, a disabled pre-distortion, an enabled digital pre-distortion, a disabled digital pre-distortion, or any combination thereof.

4. The measurement system according to any of claims 1 to 3,
wherein the measurement system, preferably the controller (13) of the measurement system, is configured to acquire a different frequency response contribution with compensated non-linearities especially by performing each permutation of at least a part of the several contributions.

5. The measurement system according to claim 4,
wherein the different frequency response contribution with compensated non-linearities gets different impact of unwanted linear effects.

6. The measurement system according to any of claims 1 to 5,
wherein the measurement system, preferably the controller (13) of the measurement system, is configured to analyze a noise contribution by command sequences creating several measurements and I/Q averaging on the signal analyzer (12).

7. The measurement system according to any of claims 1 to 6,
wherein the measurement system, preferably the controller (13) of the measurement system, is configured to compensate unwanted linear effects with command sequences comparing an ideal signal with the respective measured signal.

8. The measurement system according to any of claims 1 to 7,
wherein the measurement system, preferably the controller (13) of the measurement system, is configured to compensate unwanted linear effects by creating respective equalized values.

9. The measurement system according to any of claims 1 to 8,
wherein the measurement system, preferably the controller (13) of the measurement system, is configured to compensate unwanted linear effects with command sequences comprising pre-distortion, especially digital pre-distortion.

10. The measurement system according to any of claims 1 to 9,
wherein the measurement system, preferably the controller (13) of the measurement system, is configured to compensate unwanted linear effects with command sequences using modeling techniques, especially polynomial modeling techniques, based on the corresponding measured data.

11. The measurement system according to any of claims 1 to 10,
wherein the measurement system, preferably the controller (13) of the measurement system, is configured to illustrate respective proportions with the aid of a pie chart.

12. The measurement system according to any of claims 1 to 11,
wherein the measurement system, preferably the controller (13) of the measurement system, is configured to show respective proportions with the aid of a permutations table in order to illustrate the corresponding dependencies in the contributions.

13. The measurement system according to any of claims 1 to 12,
wherein the measurement system, preferably the controller (13) of the measurement system, is configured to highlight an intensity of a respective contribution with a corresponding color.

14. A measurement method for automated measurement of several contributions to signal degradation, the measurement method comprising the step of:
generating (100) at least one command sequence for a device under test (11) and/or a signal analyzer (12) with the aid of a controller (13),
wherein each of the at least one command sequence comprises respective commands that, when executed by the device under test (11) and/or the signal analyzer (12) with the aid of the controller (13), compensate for a specific cause of signal degradation,
eliminating or significantly reducing a certain cause of signal degradation from the device under test (11) by running at least one command sequence for different combinations of compensations to obtain a compensated measurement with the aid of the controller (13).

## Patentansprüche

1. Messsystem für eine automatisierte Messung von mehreren Beiträgen zu einer Signalverschlechterung, wobei das Messsystem Folgendes umfasst:
eine zu testende Vorrichtung (11),
einen Signalanalysator (12), und
eine Steuerung (13),
wobei die Steuerung (13) mindestens eine Befehlssequenz für die zu testende Vorrichtung (11) und/oder den Signalanalysator (12) umfasst, und
wobei jede der mindestens einen Befehlssequenz jeweilige Befehle umfasst, die, wenn sie von der zu testenden Vorrichtung (11) und/oder vom Signalanalysator (12) mithilfe der Steuerung (13) ausgeführt werden, eine spezifische Ursache der Signalverschlechterung kompensieren, und
wobei die Steuerung (13) des Messsystems dazu ausgelegt ist, durch Umsetzen von mindestens einer Befehlssequenz für verschiedene Kombinationen von Kompensierungen, um eine kompensierte Messung zu erhalten, eine bestimmte Ursache der Signalverschlechterung aus der zu testenden Vorrichtung (11) zu entfernen oder wesentlich zu reduzieren.

2. Messsystem nach Anspruch 1,
wobei das Messsystem ferner einen Signalgenerator (14) umfasst,
wobei die Steuerung (13) mindestens eine Befehlssequenz für die zu testende Vorrichtung (11) und/oder den Signalanalysator (12) und/oder den Signalgenerator (14) umfasst.

3. Messsystem nach Anspruch 1 oder 2,
wobei das Messsystem, vorzugsweise die Steuerung (13) des Messsystems, dazu ausgelegt ist, einen Bericht bereitzustellen, der die Beiträge der entsprechenden verschiedenen Ursachen der Signalverschlechterung zeigt, und/oder
wobei der Signalanalysator (12) die Steuerung (13) umfasst und/oder
wobei das Messsystem ferner einen persönlichen Computer (16) umfasst und der persönliche Computer (16) die Steuerung (13) umfasst und/oder
wobei mindestens zwei der mehreren Beiträge voneinander abhängig sind und/oder
wobei das Messsystem, vorzugsweise die Steuerung (13) des Messsystems, dazu ausgelegt ist, eine Permutation von mindestens einem Teil der mehreren Beiträge durchzuführen, und/oder
wobei die mehreren Beiträge, vorzugsweise mit Bezug auf den Signalanalysator (12), mindestens eines von einem aktivierten Entzerrer, einem deaktivierten Entzerrer, einer aktivierten Vorverzerrung, einer deaktivierten Vorverzerrung, einer aktivierten digitalen Vorverzerrung, einer deaktivierten digitalen Vorverzerrung oder eine Kombination davon umfassen.

4. Messsystem nach einem der Ansprüche 1 bis 3,
wobei das Messsystem, vorzugsweise die Steuerung (13) des Messsystems, dazu ausgelegt ist, einen anderen Frequenzgangbeitrag mit kompensierten Nichtlinearitäten zu erfassen, insbesondere durch Durchführen von jeder Permutation von mindestens einem Teil der mehreren Beiträge.

5. Messsystem nach Anspruch 4,
wobei der andere Frequenzgangbeitrag mit kompensierten Nichtlinearitäten eine andere Beeinträchtigung durch unerwünschte lineare Effekte erfährt.

6. Messsystem nach einem der Ansprüche 1 bis 5,
wobei das Messsystem, vorzugsweise die Steuerung (13) des Messsystems, dazu ausgelegt ist, durch Befehlssequenzen, die mehrere Messungen produzieren, und I/Q-Mittelung am Signalanalysator (12) einen Rauschbeitrag zu analysieren.

7. Messsystem nach einem der Ansprüche 1 bis 6,
wobei das Messsystem, vorzugsweise die Steuerung (13) des Messsystems, dazu ausgelegt ist, unerwünschte lineare Effekte mit Befehlssequenzen, die ein ideales Signal mit dem jeweiligen Messsignal vergleichen, zu kompensieren.

8. Messsystem nach einem der Ansprüche 1 bis 7,
wobei das Messsystem, vorzugsweise die Steuerung (13) des Messsystems, dazu ausgelegt ist, unerwünschte lineare Effekte durch Produzieren von jeweiligen Entzerrungswerten zu kompensieren.

9. Messsystem nach einem der Ansprüche 1 bis 8,
wobei das Messsystem, vorzugsweise die Steuerung (13) des Messsystems, dazu ausgelegt ist, unerwünschte lineare Effekte mit Befehlssequenzen, die eine Vorverzerrung, insbesondere eine digitale Vorverzerrung umfassen, zu kompensieren.

10. Messsystem nach einem der Ansprüche 1 bis 9,
wobei das Messsystem, vorzugsweise die Steuerung (13) des Messsystems, dazu ausgelegt ist, unerwünschte lineare Effekte mit Befehlssequenzen, die Modellierungstechniken, insbesondere Polynommodellierungstechniken verwenden, auf Basis der entsprechenden Messdaten zu kompensieren.

11. Messsystem nach einem der Ansprüche 1 bis 10,
wobei das Messsystem, vorzugsweise die Steuerung (13) des Messsystems, dazu ausgelegt ist, mithilfe eines Kreisdiagramms jeweilige Anteile darzustellen.

12. Messsystem nach einem der Ansprüche 1 bis 11,
wobei das Messsystem, vorzugsweise die Steuerung (13) des Messsystems, dazu ausgelegt ist, jeweilige Anteile mithilfe einer Permutationstabelle zu zeigen, um die entsprechenden Abhängigkeiten bei den Beiträgen darzustellen.

13. Messsystem nach einem der Ansprüche 1 bis 12,
wobei das Messsystem, vorzugsweise die Steuerung (13) des Messsystems, dazu ausgelegt ist, eine Stärke eines jeweiligen Beitrags mit einer entsprechenden Farbe hervorzuheben.

14. Messverfahren für eine automatisierte Messung von mehreren Beiträgen zu einer Signalverschlechterung, wobei das Messverfahren den folgenden Schritt umfasst:
Erzeugen (100) von mindestens einer Befehlssequenz für eine zu testende Vorrichtung (11) und/oder einen Signalanalysator (12) mithilfe einer Steuerung (13),
wobei jede der mindestens einen Befehlssequenz jeweilige Befehle umfasst, die, wenn sie von der zu testenden Vorrichtung (11) und/oder vom Signalanalysator (12) mithilfe der Steuerung (13) ausgeführt werden, eine spezifische Ursache der Signalverschlechterung kompensieren,
Entfernen oder wesentliches Reduzieren einer bestimmten Ursache der Signalverschlechterung aus der zu testenden Vorrichtung (11) durch Umsetzen von mindestens einer Befehlssequenz für verschiedene Kombinationen von Kompensierungen mithilfe der Steuerung (13), um eine kompensierte Messung zu erhalten.

## Revendications

1. Système de mesure pour la mesure automatisée de nombreuses contributions à une dégradation de signal, le système de mesure comprenant :
un dispositif sous test (11),
un analyseur de signaux (12), et
un dispositif de commande (13),
dans lequel le dispositif de commande (13) comprend au moins une séquence d'instructions pour le dispositif sous test (11) et/ou l'analyseur de signaux (12), et
dans lequel chacune de la ou des séquences d'instructions comprend des instructions respectives qui, lorsqu'elles sont exécutées par le dispositif sous test (11) et/ou l'analyseur de signaux (12) à l'aide du dispositif de commande (13), compensent une cause spécifique d'une dégradation de signal, et
dans lequel le dispositif de commande (13) du système de mesure est configuré pour éliminer ou réduire de manière significative une certaine cause d'une dégradation de signal du dispositif sous test (11) en exécutant au moins une séquence d'instructions pour différentes combinaisons de compensations pour obtenir une mesure compensée.

2. Système de mesure selon la revendication 1,
dans lequel le système de mesure comprend en outre un générateur de signaux (14),
dans lequel le dispositif de commande (13) comprend au moins une séquence d'instructions pour le dispositif sous test (11) et/ou l'analyseur de signaux (12) et/ou le générateur de signaux (14).

3. Système de mesure selon la revendication 1 ou 2,
dans lequel le système de mesure, de préférence le dispositif de commande (13) du système de mesure, est configuré pour fournir un rapport montrant les contributions des différentes causes respectives d'une dégradation de signal et/ou
dans lequel l'analyseur de signaux (12) comprend le dispositif de commande (13) et/ou
dans lequel le système de mesure comprend en outre un ordinateur personnel (16) et l'ordinateur personnel (16) comprend le dispositif de commande (13) et/ou
dans lequel au moins deux des nombreuses contributions dépendent l'une de l'autre et/ou
dans lequel le système de mesure, de préférence le dispositif de commande (13) du système de mesure, est configuré pour réaliser chaque permutation d'au moins une partie des nombreuses contributions et/ou
dans lequel, de préférence par rapport à l'analyseur de signaux (12), les nombreuses contributions comprennent au moins un parmi un égaliseur activé, un égaliseur désactivé, une pré-distorsion activée, une pré-distorsion désactivée, une pré-distorsion numérique activée, une pré-distorsion numérique désactivée, ou toute combinaison de ceux-ci.

4. Système de mesure selon l'une quelconque des revendications 1 à 3,
dans lequel le système de mesure, de préférence le dispositif de commande (13) du système de mesure, est configuré pour acquérir une contribution de réponse en fréquence différente avec des non-linéarités compensées, notamment en réalisant chaque permutation d'au moins une partie des nombreuses contributions.

5. Système de mesure selon la revendication 4,
dans lequel la contribution de réponse en fréquence différente avec des non-linéarités compensées a un impact différent d'effets linéaires indésirables.

6. Système de mesure selon l'une quelconque des revendications 1 à 5,
dans lequel le système de mesure, de préférence le dispositif de commande (13) du système de mesure, est configuré pour analyser une contribution de bruit par des séquences d'instructions créant de nombreuses mesures et un moyennage I/Q sur l'analyseur de signaux (12).

7. Système de mesure selon l'une quelconque des revendications 1 à 6,
dans lequel le système de mesure, de préférence le dispositif de commande (13) du système de mesure, est configuré pour compenser des effets linéaires indésirables avec des séquences d'instructions comparant un signal idéal avec le signal mesuré respectif.

8. Système de mesure selon l'une quelconque des revendications 1 à 7
dans lequel le système de mesure, de préférence le dispositif de commande (13) du système de mesure, est configuré pour compenser des effets linéaires indésirables en créant des valeurs égalisées respectives.

9. Système de mesure selon l'une quelconque des revendications 1 à 8,
dans lequel le système de mesure, de préférence le dispositif de commande (13) du système de mesure, est configuré pour compenser des effets linéaires indésirables avec des séquences d'instructions comprenant une pré-distorsion, une notamment une pré-distorsion numérique.

10. Système de mesure selon l'une quelconque des revendications 1 à 9,
dans lequel le système de mesure, de préférence le dispositif de commande (13) du système de mesure, est configuré pour compenser des effets linéaires indésirables avec des séquences d'instructions en utilisant des techniques de modélisation, notamment des techniques de modélisation polynomiale, sur la base des données mesurées correspondantes.

11. Système de mesure selon l'une quelconque des revendications 1 à 10,
dans lequel le système de mesure, de préférence le dispositif de commande (13) du système de mesure, est configuré pour illustrer des proportions respectives à l'aide d'un graphique circulaire.

12. Système de mesure selon l'une quelconque des revendications 1 à 11,
dans lequel le système de mesure, de préférence le dispositif de commande (13) du système de mesure, est configuré pour montrer des proportions respectives à l'aide d'un tableau de permutations afin d'illustrer les dépendances correspondantes dans les contributions.

13. Système de mesure selon l'une quelconque des revendications 1 à 12,
dans lequel le système de mesure, de préférence le dispositif de commande (13) du système de mesure, est configuré pour mettre en évidence une intensité d'une contribution respective avec une couleur correspondante.

14. Procédé de mesure pour la mesure automatisée de nombreuses contributions à une dégradation de signal, le procédé de mesure comprenant les étapes consistant à :
générer (100) au moins une séquence d'instructions pour un dispositif sous test (11) et/ou un analyseur de signaux (12) à l'aide d'un dispositif de commande (13),
dans lequel chacune de la ou des séquences d'instructions comprend des instructions respectives qui, lorsqu'elles sont exécutées par le dispositif sous test (11) et/ou l'analyseur de signaux (12) à l'aide du dispositif de commande (13), compensent une cause spécifique d'une dégradation de signal,
éliminer ou réduire de manière significative une certaine cause d'une dégradation de signal du dispositif sous test (11) en exécutant au moins une séquence d'instructions pour différentes combinaisons de compensations pour obtenir une mesure compensée à l'aide du dispositif de commande (13).
